# EUROPEAN PATENT APPLICATION

(11) **EP 2 124 258 A2**
(43) Date of publication of application: **25.11.2009**
(21) Application number: 09005665.6
(22) Date of filing: 22.04.2009
(51) Int. Cl.: H01L 29/778, H01L 21/335

(54) **Mos field effect transistor and manufacturing method for the same**

(30) Priority: 22.05.2008 JP 2008134381
(71) Applicant: Sharp Kabushiki Kaisha, Osaka-shi, Osaka 545-8522 (JP)
(72) Inventor: Teraguchi, Nobuaki, Osaka-shi Osaka 545-8522 (JP)
(74) Representative: Müller - Hoffmann & Partner

(57) **Abstract**

An MOS field effect transistor comprising an AlN layer (2) having a nitrogen face and relieved from stress, an AlₓGa₁₋ₓN (0 ≦x< 1) layer (3) formed on the nitrogen face, source/drain electrodes (5,6) having an ohmic electrode formed on the AlₓGa₁₋ₓN layer (3), an oxide region (4) formed between the source/drain electrodes (5,6), and a gate electrode (7) formed on the oxide region (4).

## Description

### BACKGROUND OF THE INVENTION

### 1. Field of the Invention

The present invention relates to a normally-off mode MOS field effect transistor using a group III-V type nitride compound semiconductor and a manufacturing method for the same.

### 2. Description of the Related Art

Conventionally, a gate recess treatment has been used to manufacture a normally-off mode MOS field effect transistor using a hetero-structure of AlGaN/GaN.

Further, in order to easily manufacture a normally-off mode transistor, an MOS transistor has been proposed (refer to Japanese Unexamined Patent Publication No. 2000-277724 and T.P.Chow et al., 2 members "Experimental Demonstration of Enhancement Mode GaN MOSFETs", International Workshop on Nitride Semiconductors (IWN), 2006 Technical Digest WeEd1-1. page 144).

### SUMMARY OF THE INVENTION

The present invention provides an MOS field effect transistor comprising an AlN layer having a nitrogen face and relieved from stress, an AlₓGa₁₋ₓN (0 ≦x<1) layer formed on the nitrogen face, source/drain electrodes having an ohmic electrode formed on the AlₓGa₁₋ₓN layer, an oxide region formed between the source/drain electrodes, and a gate electrode formed on the oxide region.

Further, the present invention provides a manufacturing method for the above-described MOS field effect transistor comprising the steps of::
(a) forming an AlₓGa₁₋ₓN (0≦x< 1) layer on a nitrogen face of a AlN layer having the nitrogen face and relieved from stress;
(b) forming source/drain electrodes having ohmic electrodes on the AlₓGa₁₋ₓN layer;
(c) forming an oxide region between the source/drain electrodes; and
(d) forming a gate electrode on the oxide region.

### BRIEF DESCRIPTION OF THE DRAWINGS

Fig. 1 is a schematic cross sectional view of a MOS field effect transistor according to an embodiment of the present invention (Example 1).
Fig. 2 is a schematic cross sectional view of a MOS field effect transistor according to another embodiments of the present invention (Example 2 and 3).
Figs. 3 (a) - 3(d) are schematic cross sectional views to explain effects of an MOS field effect transistor of the present invention.
Figs. 4(a) and 4(b) are schematic cross sectional views showing the conventional MOS field effect transistor.

### DESCRIPTION OF THE PREFERRED EMBODIMENTS

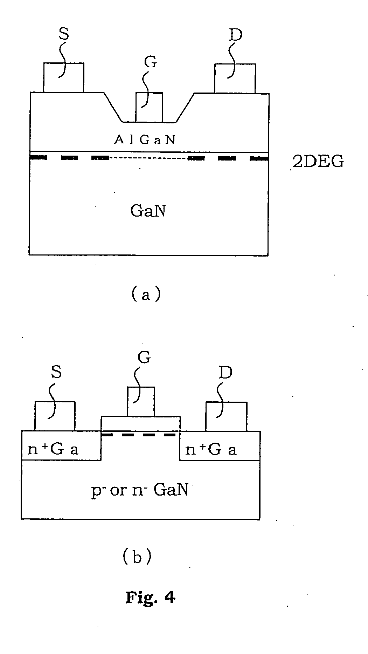

A manufacturing method for a normally-off mode transistor using a hetero-structure of AlGaN/GaN is, as shown in Fig 4(a), to make an AlGaN layer under a gate electrode [G] thin using a recess etching method, so that the density of a two-dimensional electron gas (2DEG) is made small.

However, it is difficult to reproducibly realize a normally-off characteristics using the above-mentioned method.

In Fig 4, reference marks [S] and [D] represent a source/drain electrodes, respectively.

In the MOS transistor as shown in Fig 4(b), since an oxide film for GaN is made of SiO₂, the problem is that the number of interface state is much and sufficient mobility cannot be obtained. In addition, to provide an ohmic contact in the manufacturing method, an extra ion implantation process is needed.

Accordingly, it is an object of the present invention to provide a normally-off mode MOS field effect transistor using a group III-V type nitride compound semiconductor having a small ohmic resistance, little interface state and a large mobility by less process, and its manufacturing method.

The MOS field effect transistor of the present invention is characterized by comprising an AlN layer having a nitrogen face and relieved from stress, an AlₓGa₁₋ₓN (0≦x< 1) layer formed on the nitrogen face, source/drain electrodes having an ohmic electrode formed on the AlₓGa₁₋ₓN layer, an oxide region formed between the source/drain electrodes, and a gate electrode formed on the oxide region.

According to the present invention, a normally-off mode MOS field effect transistor using a group III-V type nitride compound semiconductor having a small ohmic resistance, little interface state and a large mobility by less process, and its manufacturing method can be provided.

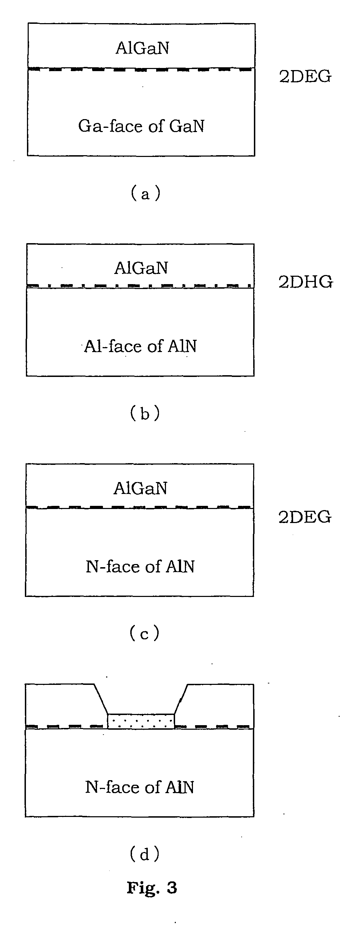

The effects of the present invention will be explained in detail with reference to Fig 3.

In a general field effect transistor having a semiconductor heterojunction (HFET), as shown in Fig 3(a), an AlGaN layer is formed on a gallium face (Ga-face) of a GaN layer having the Ga-face and relieved from stress, to thereby form a two-dimensional electron gas (2DEG; the broken line in the figure) on the GaN layer side.

On the other hand, as shown in Fig 3(b), in case where an AlGaN layer is formed on an aluminum face (Al-face) of the AlN layer having the Al-face and relieved from stress, to thereby form a two-dimensional hole gas (2DHG; the dashed line in the figure) on the AlGaN layer side.

However, it is preferable to form the 2DEG in order to utilize the electron as carriers. As shown in Fig 3(c), it is necessary to form the AlGaN layer on the nitrogen face (N-face) of the AlN layer having the N-face and relieved from stress. The broken line in the figures represents the 2DEG.

Under the circumstances, as shown in Fig 3(d), a part of the AlGaN layer on which the gate electrode is to be formed is removed to oxidize it up to the AlN layer to thereby enable an ideal interface of Al₂O₃/AlN with remarkably improving mobility.

Therefore, since the 2DEG is formed on the AlGaN layer side of the the AlN/AlGaN interface by forming the AlₓGa₁₋ₓN (0≦x< 1) layer on the N-face of the AlN layer having the N-face, the ion implantation for forming the ohmic electrodes becomes unnecessary.

Otherwise, if the oxidation process is performed without removing the AlₓGa₁₋ₓN (0≦x< 1) layer, it will take much time to oxidize the AlN layer, in which the other effects can be obtained as being similar to the above-mentioned effects.

The manufacturing method for the MOS field effect transistor of the present invention is characterized by comprising:
(a) a step of forming an AlₓGa₁₋ₓN (0≦x< 1) layer on a nitrogen face of a AlN layer having the nitrogen face and relieved from stress;
(b) a step of forming source/drain electrodes having ohmic electrodes on the AlₓGa₁₋ₓN layer;
(c) a step of forming an oxide region between the source/drain electrodes; and
(d) a step of forming a gate electrode on the oxide region. Each of the steps will be described in detail below.

### (a) The step of forming an AlₓGa₁₋ₓN (0≦x< 1) layer on a nitrogen face of a AlN layer having the nitrogen face and relieved from stress

In the present invention, the AlN layer having the nitrogen face and relieved from stress is preferably:
an AlN layer having a nitrogen face and a thickness of 0.5-10 µm, crystallized on a substrate by Hydride Vapor Phase Epitaxy (HVPE) method or Metal Organic Chemical Vapor Deposition (MOCVD) method;
an AlN layer having a nitrogen face, wherein an AlN film having an aluminum face and a thickness of 0.5-10 µm, crystallized on a substrate by HVPE method or MOCVD method is adhered to a support substrate, then the substrate is exfoliated, and then the exposed nitrogen face is made flat by Chemical Mechanical Polishing (CMP) method; and
an AlN layer having a nitrogen face, wherein an AlN film having an aluminum face and a thickness of 200-500 µm which is crystallized on a substrate by HVPE method or MOCVD method is exfoliated from the substrate, and then the exposed nitrogen face is made flat by Chemical Mechanical Polishing (CMP) method.

Examples of the substrate include, though not particularly limited to a SiC substrate, a sapphire substrate and the like.

Examples of the support substrate include, though not particularly limited to a quartz substrate, Si substrate, a glass substrate and the like, in addition to the above-mentioned substrates.

The method for crystallizing the AlN layer and the AlN film includes, though not particularly limited to, a Hydride Vapor Phase Epitaxy (HVPE) method and Metal Organic Chemical Vapor Deposition (MOCVD) method, which are especially preferable as mentioned above.

The thickness of the AlN layer and the AlN film are about 0.5-10 µm in case where the AlN layer and the AlN film have the substrate or the support substrate. It is above 200 µm and, preferably, 200-500 µm in case where the AlN layer and the AlN film do not have the substrate or the support substrate.

The conditions for the crystal growth may be desirably set.

In addition, to relieve from stress, the AlN layer may be heat-treated if necessary.

The method for adhering the AlN film having the aluminum face to the support substrate includes, though not particularly limited to, for example the adherence by an epoxy resin.

Further, the method for exfoliating the substrate from the AlN film adhered to the support substrate includes, though not particularly limited to, for example the laser irradiation.

The Chemical Mechanical Polishing (CMP) method for making the exposed nitrogen face flat is a conventional method, for example, to polish it with a polishing cloth using slurry containing diamond abrasive.

The method for forming the AlₓGa₁₋ₓN (0≦x<1) layer on the AlN layer includes, though not particularly limited to, for example, the MOCVD method, HVPE method, Gas Source Molecular Beam Epitaxy (GSMBE) method and the like. The conditions for the forming may be desirably set.

The thickness of the AlₓGa₁₋ₓN layer may be about 0.01-1 µm.

### (b) The step of forming source/drain electrodes having ohmic electrodes on the AlₓGa₁₋ₓN layer

A metal for the ohmic electrodes includes, though not particularly limited to, any metal as far as it can provide the ohmic characteristics. Ti/Al system comprising Ti/Al/Mo/Au laminated structure and Ti/Al/Nb/Au laminated structure; Hf/Al system comprising Hf/Al/Hf/Au laminated structure; and the like may be exemplified.

The metals for the ohmic electrode are laminated (deposited) on the AlₓGa₁₋ₓN layer by the conventional method, and then annealed to thereby form the source/drain electrodes having the ohmic electrodes.

Their deposition conditions may be set and the ohmic electrodes may be formed using the annealing temperatures depending on their materials.

The thickness of the ohmic electrodes may be about 10/60/10/60 nm in the case of the Hf/Al/Hf/Au laminated structure, in which the annealing temperature is about 800°C.

### (c) The step of forming an oxide region between the source/drain electrodes

The oxide region includes, though not particularly limited to, preferably an oxide layer which is formed by oxidizing a part or all of the AlₓGa₁₋ₓN layer along a longitudinal direction of the gate between the source/drain electrodes to arrive at a part of the AlN layer, or another oxide film which is formed by oxidizing a part of the AlN layer after a part or all of the AlₓGa₁₋ₓN layer along the longitudinal direction of the gate between the source/drain electrodes is removed.

Namely, it is preferable that the oxide region is an oxide film which is formed by oxidizing a part or all of the AlₓGa₁₋ₓN layer along a longitudinal direction of the gate between the source/drain electrodes arriving toward a part of the AlN layer, or another oxide film which is formed by oxidizing a part of the AlN layer after a part or all of the AlₓGa₁₋ₓN layer along a longitudinal direction of the gate between the source/drain electrodes is removed.

Preferably, the oxidation is performed by a thermal oxidation under an oxygen environment or photo-electrochemical reaction accompanying light irradiation.

During the oxidation, the portion which is not to be oxidized should be preliminarily masked by an insulator such as SiO₂. A method for forming the mask includes conventional methods such as a thermal Chemical Vapor Deposition (CVD) method, a plasma CVD method and the like. The conditions for the forming may be desirably set.

The conditions for the thermal oxidation under an oxygen environment may be desirably set depending upon the thickness of a film to be formed and an oxidation speed.

Preferably, to uniformly oxidize the film, the temperature should be selected to be, for example above 400°C and less than 800°C.

On the other hand, to make the oxidation speed fast, the temperature should be preferably set to be, for example above 800°C and less than 1200°C.

An oxygen concentration in the oxygen environment may be desirably set depending upon the oxidation speed, in which it is possible to set it up to 100%.

The oxidation time depends upon the thickness of the AlₓGa₁₋ₓN layer, the thickness of the AlN layer to be oxidized, and a partial pressure of oxygen and a temperature on the heat treatment.

The oxidation by the photo-electrochemical reaction accompanying light irradiation is preferred since the desired regions can be selectively oxidized by the light irradiation.

The conditions may be desirably set depending upon the thickness of the film to be oxidized and the oxidation speed.

Preferably, the light irradiation is performed by using a light having a wavelength of which is shorter than those corresponding to band gaps of the AlₓGa₁₋ₓN layer and the AlN layer. In this case, the holes are excited to facilitate the oxidation.

Since the wavelengths corresponding to the band gaps of the AlₓGa₁₋ₓN layer and the AlN layer are about 390-200nm and about 200nm, respectively, it is preferable that the wavelength of the light in the light irradiation is shorter than these wavelengths by about 5 nm.

The oxidation is thus made while the light having the wavelengths according to the of AlₓGa₁₋ₓN layer and AlN layer is being irradiated, to thereby improve to control the thickness of the oxide layer.

The oxidation time depends upon a thickness of the oxide layer to be oxidized, the photo-current density and the impressed voltage, which may be desirably set.

It is preferable that the removal is performed by dry etching using fluorine containing gas and chloride containing gas. The gas suitable for this purpose is a mixture gas of Cl₂ + SF₆ (ratio 10:1).

By selecting the etching gas, the AlₓGa₁₋ₓN (0 ≦x<1) layers and the AlN layers are selectively etched, so that the Al₂O₃ layer not containing Ga can be formed. Since the etching gas can contain fluorine, the etching speed of the AlN layer is abruptly reduced to thereby enable the selective etching.

### (d) The step of forming a gate electrode on the oxide region

The gate electrode may be formed by the conventional method with the conventional materials. Examples of a material for the gate electrode include metals such as Al, Cu, Au, Ag, Ni, Pd, Pt and the like; a high melting point metal such as Ta, Ti, W and the like; and their nitride. In particular, Au, Pd, Pt, and WN (the nitride of tungsten) are preferred.

The method for forming the gate electrode may be Electron Beam (EB) evaporation method, sputtering and the like. The forming conditions may be desirably set.

The gate electrode may comprise an laminated structure of different materials, whose thickness may be about 0.01-1 µm.

Before forming the gate electrode, a GaOₓ layer only of the oxide region is preliminarily etched with ammonia water (NH₄OH) to thereby improve the reproducibility, which is preferable.

### (Examples)

The present invention will be explained in detail by way of Examples, which are not intended to be limiting of the present invention.

### (Example 1)

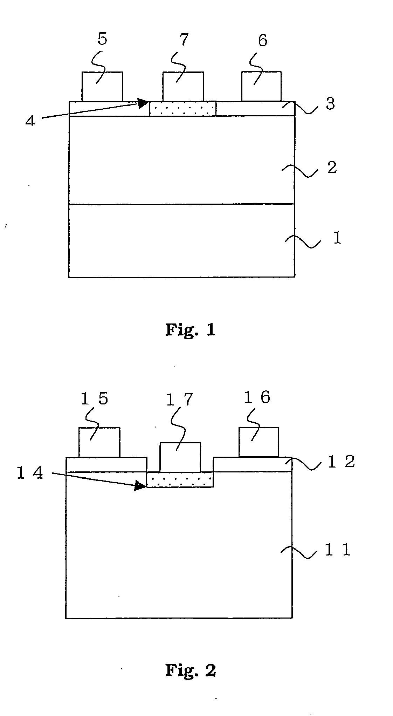

An MOS field effect transistor as shown in Fig 1 is manufactured as follows.

First of all, an AlN layer [2] having a thickness of 1.5 µm is formed on a carbon face of a SiC substrate [1] under the condition that the substrate temperature is 1150°C and the ratio of V/III is 10,000 using the MOCVD method.

Subsequently, a GaN film [3] having a thickness of 0.1 µm is formed on a nitride face of the AlN layer [2] under the condition that the temperature is 1100°C and the ratio of V/III is 20,000.

Then, a SiO₂ insulator film (not shown) having a thickness of about 1 µm is formed on the GaN film [3] using the thermal CVD method, so that a buffered fluoride acid is used to remove a part of the insulator film on which a gate electrode [7] is to be formed.

Then, the obtained SiC substrate [1] is heat-treated for two hours in a heat treat furnace of 900°C under an oxygen environment 100% to thereby oxidize a part of the AlN layer [2] and GaN layer [3] on which the gate electrode [7] is to be formed in order to finally provide an oxide region [4].

Although not shown in Fig 1, a region (its thickness is about 20 nm) adjacent to the oxide region [4] of the AlN layer [2] is oxidized.

Then, fluoride acid is used to remove the remaining insulator film, so that a Hf/Al/Hf/Au laminated structure as the metals for the ohmic electrodes are deposited by the EB evaporation method and then annealed under a nitrogen environment of 800°C for 1 minute to thereby form the source/drain electrodes [5,6].

Then, only the GaOₓ layer of in the oxide region [4] is etched by an ammonia water (NH₄OH) and the Pt/Au layers are deposited using the EB evaporation method to thereby form the gate electrode [7] so that the MOS field effect transistor of Fig 1 is manufactured.

The Id-Vg characteristic of the obtained MOS field effect transistor is evaluated in which the pinch-off characteristics occur at the gate voltage +1V, indicating that good normally-off characteristics are given.

### (Example 2)

An MOS field effect transistor as shown in Fig 2 is manufactured as follows:
First of all, an AlN film [2] having a thickness of 300 µm and an aluminum face is formed on a sapphire substrate (not shown) using the HVPE method.

Subsequently, the AlN film is exfoliated from the sapphire substrate by laser irradiation. The exposed nitrogen face is made flat by the CMP method to thereby form the AlN layer [11] having the nitrogen face.

Then, a Al_{0.15}Ga_{0.85} N film [12] having a thickness of 0.2 µm is formed on a nitride face of the AlN layer [11] using the MOCVD method under the condition that the substrate temperature is 1050°C and the ratio of V/III is 160,000.

Then, a SiO₂ insulator film (not shown) having a thickness of about 1 µm is formed on the Al_{0.15}Ga_{0.85} N film [12] using the plasma CVD method, so that buffered fluoride acid is used to remove a part of the insulator film on which the gate electrode [17] is to be formed.

Then, a part of the Al_{0.15}Ga_{0.85} N film [12] on which the gate electrode [17] is to be formed is removed by dry etching using the mixture gas of Cl₂ + SF₆ (ratio 10:1).

Then, while a laser irradiation by a He-Cd laser having a wavelength of 325nm and an output of 10 mW is applied to the part of AlN layer [11] on which the gate electrode [17] is to be formed, that part of the AlN layer [11] for providing the gate electrode [17] is oxidized up to its thickness of 10 nm by the photo-electrochemical reaction (a photo current density is 5mW/cm² and the impressed voltage is 5 V) using a glycol solution (tartaric acid + propylene glycol = ratio 2:1 + ammonia water to make its pH 7) to thereby form an oxide region [14].

Then, fluoride acid is used to remove the remaining insulator film, so that a Ti/Al/Mo/Au (15/60/35/50 nm) laminated structure as the metals for the ohmic electrodes are deposited by an EB evaporation method and then annealed under the a nitrogen environment of 800°C for 1 minute to thereby form the source/ drain electrodes [15,16].

Then, a WN layer is deposited by sputtering to thereby form the gate electrode [17] so that the MOS field effect transistor of Fig 2 is manufactured.

The Id-Vg characteristic of the obtained MOS field effect transistor is evaluated in which the pinch-off characteristics occur at the gate voltage +1V, indicating that good normally-off characteristics are given.

### (Example 3)

An MOS field effect transistor as shown in Fig 2 is manufactured as follows:
First of all, an AlN film having a thickness of 300 µm and an aluminum face is formed on a sapphire substrate (not shown) using the HVPE method.

Subsequently, the AlN film is exfoliated from the sapphire substrate by laser irradiation. The exposed nitrogen face is made flat by the CMP method to thereby form the AlN layer [11] having the nitrogen face.

Then, a Al_{0.3}Ga_{0.7} N film [12] having a thickness of 0.2 µm is formed on a nitride face of AIN layer [11] using the MOCVD method under the condition that the substrate temperature is 1050°C and the ratio of V/III is 160,000.

Then, a SiO2 insulator film (not shown) having a thickness of about 1 µm is formed on the Al_{0.3}Ga_{0.7} N film [12] using the plasma CVD method, so that buffered fluoride acid is used to remove a part of the insulator film on which the gate electrode [17] is to be formed.

Then, a part of the Al_{0.3}Ga_{0.7}N film [12] on which the gate electrode [17] is to be formed is removed selectively by photochemical etching by radiating it with ultraviolet light using a halogen lamp.

The AlGaOₓ layer formed by the photochemical etching is etched up to the AlN layer [11] using an ammonia water heated at 60 °C.

Then, while ultraviolet using the halogen lamp is applied to the part of AlN layer [11] on which the gate electrode [17] is to be formed, that part of the AlN layer [11] for providing the gate electrode [17] is oxidized up to its thickness of 10 nm by the photo-electrochemical reaction (the photo current density is 5mW/cm² and the impressed voltage is 5 V) using a glycol solution (tartaric acid + propylene glycol = ratio 2:1 + ammonia water to make its pH 7) to thereby form the oxide region [14].

Then, fluoride acid is used to remove the remaining insulator film, so that the Ti/Al/Mo/Au (15/60/35/50 nm) laminated structure as the metals for the ohmic electrodes are deposited by a sputtering and then annealed under a nitrogen environment of 800°C for 1 minute to thereby form the source/ drain electrodes [15,16].

Then, a WN layer is deposited by sputtering to thereby form the gate electrode [17] so that the MOS field effect transistor of Fig 2 is manufactured.

The Id-Vg characteristic of the obtained MOS field effect transistor is evaluated in which the pinch-off characteristics occur at the gate voltage + 1 V, indicating that good normally-off characteristics are given.

## Claims

1. An MOS field effect transistor comprising an AlN layer having a nitrogen face and relieved from stress, an AlₓGa₁₋ₓN (0 ≦x<1) layer formed on the nitrogen face, source/drain electrodes having an ohmic electrode formed on the AlₓGa₁₋ₓN layer, an oxide region formed between the source/drain electrodes, and a gate electrode formed on the oxide region.

2. The MOS field effect transistor according to claim 1, wherein the oxide region includes an oxide layer which is formed by oxidizing a part or all of the AlₓGa₁₋ₓN layer along a longitudinal direction of the gate between the source/drain electrodes to arrive at a part of the AlN layer, or another oxide film which is formed by oxidizing a part of the AlN layer after a part or all of the AlₓGa₁₋ₓN layer along the longitudinal direction of the gate between the source/drain electrodes is removed.

3. The MOS field effect transistor according to claim 1 or 2, wherein the AlN layer having the nitrogen face and relieved from stress is:
an AlN layer having a nitrogen face and a thickness of 0.5-10 µm, crystallized on a substrate by Hydride Vapor Phase Epitaxy (HVPE) method or Metal Organic Chemical Vapor Deposition (MOCVD) method;
an AlN layer having a nitrogen face, wherein an AlN film having an aluminum face and a thickness of 0.5-10 µm, crystallized on a substrate by HVPE method or MOCVD method is adhered to a support substrate, then the substrate is exfoliated, and then the exposed nitrogen face is made flat by Chemical Mechanical Polishing (CMP) method; or
an AlN layer having a nitrogen face, wherein an AlN film having an aluminum face and a thickness of 200-500 µm which is crystallized on a substrate by HVPE method or MOCVD method is exfoliated from the substrate, and then the exposed nitrogen face is made flat by Chemical Mechanical Polishing (CMP) method.

4. The MOS field effect transistor according to claim 3, wherein the substrate is a SiC substrate or a sapphire substrate.

5. A manufacturing method for the MOS field effect transistor according to claim 1, comprising the steps of:
(a) forming an AlₓGa₁₋ₓN (0≦x<1) layer on a nitrogen face of a AlN layer having the nitrogen face and relieved from stress;
(b) forming source/drain electrodes having ohmic electrodes on the AlₓGa₁₋ₓN layer;
(c) forming an oxide region between the source/drain electrodes; and
(d) forming a gate electrode on the oxide region.

6. The method according to claim 5, wherein the oxide region is an oxide film which is formed by oxidizing a part or all of the AlₓGa₁₋ₓN layer along a longitudinal direction of the gate between the source/drain electrodes arriving toward a part of the AlN layer, or another oxide film which is formed by oxidizing a part of the AlN layer after a part or all of the AlₓGa₁₋ₓN layer along a longitudinal direction of the gate between the source/drain electrodes is removed.

7. The method according to claim 6, wherein the oxidation is performed by a thermal oxidation under an oxygen environment or photo-electrochemical reaction accompanying light irradiation.

8. The method according to claim 7, wherein the light irradiation is performed by using a light having a wavelength of which is shorter than those corresponding to band gaps of the AlₓGa₁₋ₓN layer and the AlN layer.

9. The method according to any one of claims 6 to 8, wherein the removal is performed by dry etching using fluorine containing gas and chloride containing gas.
